(19) Europäisches Patentamt
European Patent Office
Office européen des brevets

(11) EP 1 963 567 B1

(12) **EUROPEAN PATENT SPECIFICATION**

(45) Date of publication and mention of the grant of the patent:
**27.10.2010 Bulletin 2010/43**

(21) Application number: **06840315.3**

(22) Date of filing: **19.12.2006**

(51) Int Cl.:
***D21H 11/20*** *(2006.01)*

(86) International application number:
**PCT/US2006/062314**

(87) International publication number:
**WO 2007/076364 (05.07.2007 Gazette 2007/27)**

(54) **PIPD PAPER AND COMPONENTS MADE THEREFROM**

PIPD-PAPIER UND DARAUS HERGESTELLTE KOMPONENTEN

PAPIER PIPD ET COMPOSANTS OBTENUS À PARTIR DE CELUI-CI

(84) Designated Contracting States:
**DE FR GB IT NL**

(30) Priority: **21.12.2005 US 753060 P**

(43) Date of publication of application:
**03.09.2008 Bulletin 2008/36**

(73) Proprietor: **E.I. DU PONT DE NEMOURS AND COMPANY**
**Wilmington, DE 19898 (US)**

(72) Inventor: **LEVIT, Mikhail, R.**
**Glen Allen, Virginia 23059 (US)**

(74) Representative: **Heinemann, Monica**
**Abitz & Partner**
**Patentanwälte**
**Postfach 86 01 09**
**81628 München (DE)**

(56) References cited:
**US-A- 4 698 267** **US-A- 4 729 921**
**US-A- 5 137 768**

- **DOETZE J. SIKKEMA: "Advances in M5 (PIPD) fiber properties and expectations from fiber theories" POLYMER FIBRES 2002: MANCHESTER 10-12 JULY, [Online] 17 July 2002 (2002-07-17), XP002442098 Retrieved from the Internet: URL:http://www.nonwoven.co.uk/reports/poly mer%20fibres%202002%20contents.html> [retrieved on 2007-07-11]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 963 567 B1

## Description

### FIELD OF THE INVENTION

The present invention concerns papers containing polypyridobisimidazole fiber and a binder material and structural components made therefrom.

### BACKGROUND OF THE INVENTION

High performance papers have been made from aramid fibers. See, for example, U.S. Patent Nos. 2,999,788, 3,756,908, and 4,472,241. Some aramid papers have been impregnated with resins. See, for example, U.S. Patent Nos. 4,698,267, 4,729,921, 5,223,094, and 5,314,742.

Fibrous articles which function as a structural core between exterior skins is commonly known as a type of a "sandwich panel." One commonly used sandwich panel is a corrugated panel used in light-weight box construction. Another core structure is the honeycomb core. Honeycomb cores have a plurality of hollow, columnar honeycomb cells separated by cell walls adhered linearly to each other. Aramid fibers have been used in some core structures to impart flame-resistance, stiffness, strength and toughness to the structures. See, for example, U.S. Patent Nos. 5,137,768 and 6,544,622.

There is a need for papers useful in structural components with improved properties.

### SUMMARY OF THE INVENTION

In some embodiments, the invention concerns a paper useful as an structural component, the paper comprising 20 to 100 percent by weight of polypyridobisimidazole fiber and optionally a binder material, wherein the paper has (i) a density of 0.08 to 1.5 grams per cubic centimeter and (ii) a basis weight of from 10 to 150 grams per square meter, and the paper, when impregnated with at least 15 % by weight of phenolic resin, has a specific tensile stiffness of at least 100 (N/cm)/(g/$m^2$), wherein the weight % is based on the total weight of the paper and resin.

In certain embodiments, binder material is phenolic resin. Other resins, as well as fibrids, pulps from other than polypyridobisimidazole polymers, thermoplastic floc and thermoplastic powder can be used as a binder material for this papers.

One preferred polypyridobisimidazole fiber is PIPD. In some embodiments, the paper has 70 to 90 percent by weight PIPD fiber

Some papers have a specific tensile stiffness after impregnation with phenolic resin of 110-150 (N/cm) /(g/$m^2$).

Some papers have a Gurley Hill porosity of from 1 to 20 seconds. Other papers have a Gurley Hill porosity of from 5 to 12 seconds.

Certain paper have a density of 0.6 to 1.2 grams per cubic centimeter. Some papers have a basis weight of from 15 to 65 grams per square meter.

Some papers further comprise at least one of conductive fillers, antioxidants, pigments, and catalysts.

In some embodiments, the PIPD fiber is in the form of the floc. In other embodiments, the PIPD fiber is in the form of the pulp. In other embodiments, the PIPD fiber is a blend of PIPD floc and PIPD pulp.

Also provided are structural cores comprising a paper described herein. Some core structures are honeycomb core structures.

The invention also relates to folded paper cores, printed wiring boards, or a sandwich panel comprising a paper described herein.

Further embodiments concern a method of making a paper comprising forming a slurry of polypyridobisimidazole fiber and removing at least a portion of the water in one or more steps to form a paper; where the paper has (i) a density of 0.08 to 1.5 grams per cubic centimeter; (ii) a basis weight of from 10 to 150 grams per square meter; and (iii) a specific tensile stiffness after impregnation with phenolic resin of at least 100 (N/cm)/(g/$m^2$).

In some embodiments, the paper is made by removing a portion of the water from the slurry to form a wet paper; and then drying the wet paper.

In some embodiments, a method of making the paper involves calendering of the formed sheet at ambient or increased temperature.

### DETAILED DESCRIPTION OF ILLUSTRATIVE EMBODIMENTS

In some embodiments, the invention concerns a paper useful as an structural component, the paper comprising 20 to 100 percent by weight of polypyridobisimidazole fiber and, optionally, a binder material, wherein the paper has (i) a density of 0.08 to 1.5 grams per cubic centimeter and (ii) a basis weight of from 10 to 150 grams per square meter,

and the paper, when impregnated with at least 15 % by weight of phenolic resin, has a specific tensile stiffness of at least 100 (N/cm)/(g/m$^2$), wherein the weight % is based on the total weight of the paper and resin.

In some embodiments, the paper comprises 30 to 97 percent by weight of polypyridobisimidazole fiber.

For the purpose of this invention, "Papers" are flat sheets producible on a paper machine, such as a Fourdrinier or inclined-wire machine. In preferred embodiments these sheets are generally thin, fibrous sheets comprised of a network of randomly oriented, short fibers laid down from a water suspension and bonded together by their own chemical attraction, friction, entanglement, binder, or a combination thereof.

The floc of this invention means short lengths of fiber, shorter than staple fiber. The length of floc is about 0.5 to about 15 mm and a diameter of 4 to 50 micrometers, preferably having a length of 1 to 12 mm and a diameter of 8 to 40 micrometers. Floc that is less than about 1 mm does not add significantly to the strength of the material in which it is used. Floc or fiber that is more than about 15 mm often does not function well because the individual fibers may become entangled and cannot be adequately and uniformly distributed throughout the material or slurry. Floc is generally made by cutting continuous spun filaments or tows into specific-length pieces using conventional fiber cutting equipment. Gcncrally this cutting is made without significant or any fibrillation of the fiber.

Fibrids are non-granular, fibrous or film-like, particles that can be used as binders in papers. Preferably, they have a melting point or decomposition point above 320°C. Fibrids are not fibers, but they are fibrous in that they have fiber-like regions connected by webs. Fibrids have an average length of 0.2 to 1 mm and a ratio of maximum to minimum dimension of 5:1 to 10:1. The thickness dimension of the fibrid web is less than 1 or two microns and typically on the order of a fraction of a micron. Fibrids, before being dried, can be used wet and can be deposited as a binder physically entwined about other ingredients or components of a product. The fibrids can be prepared by any method including using a fibridating apparatus of the type disclosed in U.S. Patent No. 3,018,091 where a polymer solution is precipitated and sheared in a single step.

The instant invention utilizes polypyridobisimidazole fiber. This fiber is made from a rigid rod polymer that is of high strength. The polypyridobisimidazole polymer of this fiber has an inherent viscosity of at least 20 dl/g or at least 25 dl/g or at least 28 dl/g. Such fibers include PIPD fiber (also known as M5® fiber and fiber made from poly[2,6-diimidazo [4,5-b:4,5-e]- pyridinylene-1,4(2,5-dihydroxy)phenylene). PIPD fiber is based on the structure:

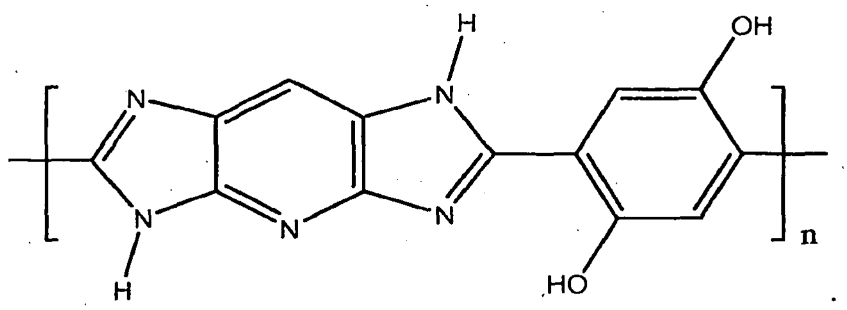

Polypyridobisimidazole fiber can be distinguished from the well known commercially available PBI fiber or polybenzimidazole fiber in that that polybenzimidazole fiber is a polybibenzimidazole. Polybibenzimidazole fiber is not a rigid rod polymer and has low fiber strength and low tensile modulus when compared to polypyridobisimidazoles.

PIPD fibers have been reported to have the potential to have an average modulus of about 310 GPa (2100 grams/denier) and an average tenacity of up to about 5.8 Gpa (39.6 grams/denier). These fibers have been described by Brew, et al., Composites Science and Technology 1999, 59, 1109; Van der Jagt and Beukers, Polymer 1999, 40, 1035; Sikkema, Polymer 1998, 39, 5981; Klop and Lammers, Polymer, 1998, 39, 5987; Hageman, et al., Polymer 1999, 40, 1313.

One method of making rigid rod polypyridoimidazole polymer is disclosed in detail in United States Patent 5,674,969 to Sikkema et al. Polypyridoimidazole polymer may be made by reacting a mix of dry ingredients with a polyphosphoric acid (PPA) solution. The dry ingredients may comprise pyridobisimidazole-forming monomers and metal powders. The polypyridobisimidazole polymer used to make the rigid rod fibers used in the fabrics of this invention should have at least 25 and preferably at least 100 repetitive units.

For the purposes of this invention, the relative molecular weights of the polypyridoimidazole polymers are suitably characterized by diluting the polymer products with a suitable solvent, such as methane sulfonic acid, to a polymer concentration of 0.05 g/dl, and measuring one or more dilute solution viscosity values at 30°C. Molecular weight development of polypyridoimidazole polymers of the present invention is suitably monitored by, and correlated to, one or more dilute solution viscosity measurements. Accordingly, dilute solution measurements of the relative viscosity ("$V_{rel}$" or "$\eta_{rel}$" or "$n_{rel}$") and inherent viscosity ("$V_{inh}$" or "$\eta_{inh}$" or "$n_{inh}$") are typically used for monitoring polymer molecular

weight. The relative and inherent viscosities of dilute polymer solutions are related according to the expression

$$V_{inh} = ln\,(V_{rel}) / C,$$

where *ln* is the natural logarithm function and C is the concentration of the polymer solution. $V_{rel}$ is a unitless ratio of the polymer solution viscosity to that of the solvent free of polymer, thus $V_{inh}$ is expressed in units of inverse concentration, typically as deciliters per gram ("dl/g"). Accordingly, in certain aspects of the present invention the polypyridoimidazole polymers are produced that are characterized as providing a polymer solution having an inherent viscosity of at least about 20 dl/g at 30°C at a polymer concentration of 0.05 g/dl in methane sulfonic acid. Because the higher molecular weight polymers that result from the invention disclosed herein give rise to viscous polymer solutions, a concentration of about 0.05 g/dl polymer in methane sulfonic acid is useful for measuring inherent viscosities in a reasonable amount of time.

Exemplary pyridobisimidazole-forming monomers useful in this invention include 2,3,5,6-tetraaminopyridine and a variety of acids, including terephthalic acid, bis-(4-benzoic acid), oxy-bis-(4-benzoic acid), 2,5-dihydroxyterephthalic acid, isophthalic acid, 2,5-pyridodicarboxylic acid, 2,6-napthalenedicarboxylic acid, 2,6-quinolinedicarboxylic acid, or any combination thereof. Preferably, the pyridobisimidazole forming monomers include 2,3,5,6-tetraaminopyridine and 2,5-dihydroxyterephthalic acid. In certain embodiments, it is preferred that that the pyridoimidazolc-forming monomers arc phosphorylated. Preferably, phosphorylated pyridoimidazole-forming monomers are polymerized in the presence of polyphosphoric acid and a metal catalyst.

Metal powders can be employed to help build the molecular weight of the final polymer. The metal powders typically include iron powder, tin powder, vanadium powder, chromium powder, and any combination thereof.

The pyridobisimidazole-forming monomers and metal powders are mixed and then the mixture is reacted with polyphosphoric acid to form a polypyridoimidazole polymer solution. Additional polyphosphoric acid can be added to the polymer solution if desired. The polymer solution is typically extruded or spun through a die or spinneret to prepare or spin the filament.

PIPD pulp has a high affinity for water, meaning the pulp has a high moisture content. This is believed to help eliminate static effects that cause clumping and defects normally associated with other high performance pulps that do not absorb water to the same degree and are afflicted with static problems. In addition, both PIPD pulp and PIPD floc have the surprising attribute of self-bonding; that is, papers formed solely from the pulp or solely from the floc have a surprisingly higher strength than would be anticipated by the prior art papers made from high performance fibers. While not wanting to be bound by theory, it is believed that this higher strength is due to hydrogen bonding between the surfaces of the pieces of pulp and floc.

PIPD pulp can be made from conventional pulp making process well known to those skilled in the art. See, for example, Handbook for Pulp & Paper Technologists, Smook, Gary A.; Kocurek, M.J.; Technical Association of the Pulp and Paper Industry; Canadian Pulp and Paper Association, and US 5,171,402 and US 5,084,136 to Haines et al.

In addition to PIPD fiber, the paper composition of this invention includes a binder material chosen from the group consisting of thermoset and thermoplastic resins in the form of solutions, emulsions, suspensions, powders, flakes, and fibers; fibrids; and pulps from other polymers outside of PIPD. The binder material can be introduced to the paper composition in the papermaking process or later. Thus, formed and calendered papers can be impregnated with resin solutions, emulsions, suspensions or powders after the papermaking process is completed.

In preferred embodiments, phenolic, epoxy or other resins easily impregnate the papers of this invention. One measure of the ability to be impregnated by resins is represented by the porosity of the paper as measured by a "Gurley Hill porosity, which measures how fast a set volume of air passes through the paper. The papers of this invention that have a Gurley Hill porosity of from 1 to 20 seconds are believed to be easily impregnated by resins. In other embodiments papers of this invention that have a Gurley Hill porosity of from 5 to 12 seconds are especially preferred.

Likewise, papers of this invention have a density of 0.08 to 1.5 grams per cubic centimeter, and in some embodiments have a density of 0.6 to 1.2 grams per cubic centimeter.

Paper from PIPD pulp, for example, can be made by a process comprising of the following steps: (a) preparing an aqueous dispersion of PTPD pulp; (b) diluting the aqueous dispersion in a paper making mold cavity: (c) draining the water from the aqueous dispersion to yield a wet paper; (d) dewatering and drying the resultant paper; and (e) conditioning the paper for physical property testing.

The papers described herein are useful for structural composites.. Construction of such structures from papers are well known by those skilled in the art. Structures using the papers described herein include honeycomb core structures, folded paper cores, printed wiring boards, and sandwich panels.

For the usage in structural composites, the papers of this invention can be additionally impregnated with different resins. If some resin was already used as a binder for the paper structure on the step of the papermaking or after that,

an additional resin can be the same or different but compatible with the first one.

**Test Methods**

In the non-limiting examples that follow, the following test methods were employed to determine various reported characteristics and properties. ASTM refers to the American Society of Testing Materials. TAPPI refers to Technical Association of Pulp and Paper Industry.

Thickness and Basis Weight of papers were determined in accordance with ASTM D 645 and ASTM D 646 correspondingly. Thickness measurements were used in the calculation of the apparent density of the papers.

Density (Apparent Density) of papers was determined in accordance with ASTM D 202.

Tensile Strength and Modulus were determined for papers and composites of this invention on an Instron-type testing machine using test specimens 2.54 cm wide and a gage length of 18 cm in accordance with ASTM D 828.

Canadian Standard Freeness (CSF) of the pulp is a measure of the rate, at which a dilute suspension of pulp may be drained, and was determined in accordance with TAPPI Test Method T 227.

Fiber length was measured in accordance with TAPPI Test Method T 271 using the Fiber Quality Analyzer manufactured by OpTest Equipment Inc.

Gurley Air Porosity (Resistance) for papers was determined by measuring air resistance in seconds per 100 milliliters of cylinder displacement for approximately 6.4 square centimeters circular area of a paper using a pressure differential of 1.22 kPa in accordance with TAPPI T 460.

Tensile Stiffness was determined for papers of this invention on an Instron-type testing machine using test specimens 2.54 cm wide and a gage length of 18 cm in accordance with ASTM D 828. Specific Tensile Stiffness was determined as a mathematical quantity calculated by dividing tensile stiffness by basis weight of the paper.

**Examples**

Examples 1-3 demonstrate the preparation and properties of papers containing PIPD fiber in the form of the pulp. The tensile strength of all papers, which composition includes PIPD pulp, satisfied boundary equation:

$$\text{Tensile strength} > \text{or} = 0.00057X * Y,$$

where X is the volume portion of PIPD pulp in the total solids of the paper in % and Y is basis weight of the paper in g/m$^2$. The high strength of PIPD-pulp-based papers gave them significant advantage in the paper manufacturing and in the further processing of the paper into the final application (it is possible to go to lighter basis weight and/or to use more simple and cheaper equipment). It is still possible to use an additional binder on the papermaking step, as shown in example 3, where meta-aramid fibrids are working as such binder. However, in the case of PIPD fiber based papers it is optional, not absolutely necessary thing.

Examples 4-6 demonstrate the preparation of calendered papers based on the formed papers from Examples 1-3. For many composite applications, a high density paper is desired, and calendering is a method of achieving that density.

Examples 7-9 demonstrate resin impregnated papers (with relatively small resin content) based on PIPD pulp and its composition with para-aramid floc. In comparative Example A, resin impregnated paper based on the commercial composition of para-aramid floc and meta-aramid fibrids is described. It can be seen that, at about the same resin content, PIPD pulp based papers provide the same or higher stiffness and much higher strength.

Comparative example A shows that even at higher para-aramid floc content in the paper composition in this case vs. example 9, stiffness and strength of the resin impregnated sheet is still lower if to compare to example 9.

**Example 1**

3.2 g (dry weight) of the PIPD pulp with CSF of about 200 ml was placed in a Waring Blender with 300 ml of water and agitated for 1 min. The dispersion was poured into an approximately 21x21 cm handsheet mold and mixed with additional 5000 g of water. A wct-laid sheet was formed. The sheet was placed between two pieces of blotting paper, hand couched with a rolling pin, and dried in a handsheet dryer at 190 C. The composition and properties of the final paper are shown in Table 1.

**Example 2**

1.6 g (dry weight) of PIPD pulp with CSF of about 300 ml was placed in a Waring Blender with 800 ml of water and agitated for 1 min. 1.6 g of para-aramid floc were placed with about 2500 g water in the laboratory pulp disintegrator and agitated for 3 minutes. The para-aramid floc was poly (para-phenylene terephthalamide) floc having a linear density of about 0.16 tex and cut length of about 0.67 cm (sold by E. T. de Pont de Nemours and Company under trademark KEVLAR® 49).

The both dispersions were poured together into an approximately 21x21 cm handsheet mold and mixed with additional 5000 g of water. A wet-laid sheet was formed. The sheet was placed between two pieces of blotting paper, hand couched with a rolling pin, and dried in a handsheet dryer at 190 C. The composition and properties of the final paper are shown in Table 1.

**Example 3**

0.64 g (dry weight) of PIPD pulp with CSF of about 300 ml was placed in a Waring Blender with 800 ml of water and agitated for 1 min. 2.24 g of para-aramid floc and 0.32 g (based on the dry weight) of never dried meta-aramid fibrids with CSF about 40 ml were placed with about 2500 g water in the laboratory pulp disintegrator and agitated for 3 minutes. The para-aramid floc was poly (para-phenylene terephthalamide) floc having a linear density of about 0.16 tex and cut length of about 0.67 cm (sold by E. I. de Pont de Nemours and Company under trademark KEVLAR® 49). The meta-aramid fibrids were made from poly(metaphenylene isophthalamide) as described in U.S. Pat No. 3,756,908.

The both dispersions were poured together into an approximately 21x21 cm handsheet mold and mixed with additional 5000 g of water. A wet-laid sheet was formed. The sheet was placed between two pieces of blotting paper, hand couched with a rolling pin, and dried in a handsheet dryer at 190 C. The composition and properties of the final paper are shown in Table 1.

**Examples 4-6**

After drying, the paper samples produced in Examples 1-3, respectively, were calendered in the nip of metal-metal calender at temperature of about 300 C and linear pressure of about 1200 N/cm. The properties of the final papers are shown in Table 1.

**Examples 7-9**

Resin impregnated papers were prepared by the impregnation of the papers from Examples 4-6 with a solvent-based phenolic resin (PLYOPHEN 23900 from the Durez Corporation) following by removing any excess resin from the surface with blotting paper and curing in an oven by ramping up the temperature as follows: heating from room temperature to 82°C and holding at this temperature for 15 minutes, increasing the temperature to 121 °C and holding at this temperature for another 15 minutes and increasing the temperature to 182°C and holding at this temperature for 60 minutes. Properties of the final impregnated papers are shown in Table 2.

**Comparative Example A**

0.64 g (of the dry weight) of meta-aramid fibrids with CSF of about 40 ml and 2.56 g of para-aramid floc were placed with about 2500 g water in the laboratory pulp disintegrator and agitated for 3 minutes. The mcta-aramid fibrids were made from poly(metaphenylene isophthalamide) as described in U.S. Pat No. 3,756,908. The para-aramid floc was the same as in Example 2. The dispersion was poured into an approximately 21x21 cm handsheet mold and mixed with additional 5000 g of water. A wet-laid sheet was formed. The sheet was placed between two pieces of blotting paper, hand couched with a rolling pin, and dried in a handsheet dryer at 190 C. After that, the paper was calendered in the nip of metal-metal calender at temperature of about 300 C and linear pressure of about 1200 N/cm. And impregnated with phenolic resin as described in examples 7-9. The composition and properties of the final impregnated paper are shown in Table 2.

**Table 1 - Properties of the paper samples with basis weight 68 g/m².**

| Ex | Paper composition, wt.% PIPD pulp | p-aramid floc | m-aramid fibrids | Paper density, g/cm³ | Volute % of PIPD pulp in solids | Boundary strength, N/cm. | Tensile strength of the paper, N/cm |
|---|---|---|---|---|---|---|---|
| 1 | 100 | -- | -- | 0.36 | 100 | 3.85 | 4.90 |
| 2 | 50 | 50 | -- | 0.22 | 45.9 | 1.77 | 3.68 |
| 4 | 100 | -- | -- | 1.16 | 100 | -- | 9.22 |
| 5 | 50 | 50 | -- | 1.02 | 45.9 | -- | 9.49 |
| 3 | 20 | 70 | 10 | 0.20 | 17.0 | 0.66 | 5.8 |
| 6 | 20 | 70 | 10 | 1.00 | 17.0 | ---- | 21.7 |
| | | | | | | | |

**Table 2 - Properties of the resin impregnated composite sheets based on 68 g/m² calendered papers**

| Example | Paper composition, wt.% PIDP pulp aramid | p-aramid floc | m-fibrids | Resin content in the composite, wt. % | Specific tensile stiffness, (N/cm)/(g/m²) | Tensile strength, N/cm |
|---|---|---|---|---|---|---|
| 7 | 100 | -- | --- | 15 | 74 | 114 |
| 8 | 50 | 50 | --- | 26 | 98 | 109 |
| 9 | 20 | 70 | 10 | 23 | 113 | 87 |
| Comp. A | --- | 80 | 20 | 21 | 77 | 58 |

**Claims**

1. A paper useful as an structural component, the paper comprising 20 to 100 percent by weight of polypyridobisimidazole fiber and optionally a binder material, wherein the paper has (i) a density of 0.08 to 1.5 grams per cubic centimeter and (ii) a basis weight of from 10 to 150 grams per square meter, and the paper, when impregnated with at least 15 % by weight of phenolic resin, has a specific tensile stiffness of at least 100 (N/cm)/(g/m²), wherein the weight % is based on the total weight of the paper and resin.

2. The paper of claim 1 wherein the binder material is chosen from the group consisting of thermoset and thermoplastic resins in the form of solutions, emulsions, suspensions, powders, flakes, and fibers; fibrids; and pulps from polymers other than polypyridobisimidazole.

3. The paper of claim 1 wherein the polypyridobisimidazole fiber is PIPD.

4. The paper of claim 1 having a specific tensile stiffness after impregnation with phenolic resin of 110-150 (N/cm)/(g/m²).

5. The paper of claim 1 having a Gurley Hill porosity of from 1 to 20 seconds, peferably of from 5 to 12 seconds.

6. The paper of claim 3 having 70 to 90 percent by weight PIPD fiber.

7. The paper of claim 1 having a density of 0.6 to 1.2 grams per cubic centimeter.

8. The paper of claim 1 further comprising at least one of conductive fillers, antioxidants, pigments, and catalysts.

9. The paper of claim 1 wherein PIPD fiber is introduced into the paper in the form of the floc.

**10.** The paper of claim 1 wherein PIPD fiber is introduced into the paper in the form of the pulp.

**11.** The paper of claim 1 wherein PIPD fiber is introduced into the paper as a blend of PIPD floc and PIPD pulp.

**12.** A structural core, a honeycomb core, a folded paper core, a printed wiring board or a sandwich panel comprising the paper of claim 1.

**13.** A method of making a paper comprising:

forming a slurry of polypyridobisimidazole fiber and optionally a binder; and
removing at least a portion of the water in one or more steps to form a paper;
wherein the paper has (i) a density of 0.08 to 1.5 grams per cubic centimeter and (ii) a basis weight of from 10 to 150 grams per square meter, and the paper, when impregnated with at least 15 % by weight of phenolic resin, has a specific tensile stiffness of at least 100 (N/cm)/(g/$m^2$), wherein the weight % is based on the total weight of the paper and resin.

**14.** The method of claim 13 further comprising calendering of the formed paper at ambient or increased temperature.

**15.** The method of claim 13 wherein the polypyridobisimidazole fiber is PIPD.

**Patentansprüche**

**1.** Papier, das nützlich ist als Konstruktionsteil, wobei das Papier 20 bis 100 Ges.-% Polypyridobisimidazol-Fasern und wahlweise ein Bindermaterial umfasst, wobei das Papier (i) eine Dichte von 0,08 bis 1,5 Gramm pro Kubikzentimeter und (ii) ein Basisgewicht von 10 bis 150 Gramm pro Quadratmeter aufweist, und das Papier, wenn es mit mindestens 15 Gew.-% Phenolharz imprägniert wird, eine spezifische Zugsteifigkeit von mindestens 100 (N/cm)/(g/$m^2$) aufweist, wobei das Gewichtsprozent auf dem Gesamtgewicht des Papiers und des Harzes basiert.

**2.** Papier nach Anspruch 1, wobei das Bindermaterial ausgewählt ist aus der Gruppe bestehend aus duroplastischen und thermoplastischen Harzen in Form von Lösungen, Emulsionen, Suspensionen, Pulvern, Flocken und Fasern; Fibriden; und Pulpen aus Polymeren, die nicht Polypyridobisimidazol sind.

**3.** Papier nach Anspruch 1, wobei die Polypyridobisimidazol-Faser PIPD ist.

**4.** Papier nach Anspruch 1, das eine spezifische Zugsteifigkeit nach dem Imprägnieren mit Phenolharz von 110-150 (N/cm)/(g/$m^2$) aufweist.

**5.** Papier nach Anspruch 1, das eine Gurley-Hill-Porosität von 1 bis 20 Sekunden, vorzugsweise von 5 bis 12 Sekunden aufweist.

**6.** Papier nach Anspruch 3, das 70 bis 90 Ges.-% PIPD-Fasern aufweist.

**7.** Papier nach Anspruch 1, das eine Dichte von 0,6 bis 1,2 Gramm pro Kubikzentimeter aufweist.

**8.** Papier nach Anspruch 1, ferner umfassend mindestens eines von leitfähigen Füllstoffen, Antioxidantien, Pigmenten und Katalysatoren.

**9.** Papier nach Anspruch 1, wobei die PIPD-Faser in Flockenform in das Papier eingearbeitet wird.

**10.** Papier nach Anspruch 1, wobei die PIPD-Faser in Pulpenform in das Papier eingearbeitet wird.

**11.** Papier nach Anspruch 1, wobei die PIPD-Faser als Mischung von PIPD-Flocken und PIPD-Pulp in das Papier eingearbeitet wird.

**12.** Struktureller Kern, Honigwabenkern, gefalteter Papierkern, gedruckte Leiterplatte oder Sandwichplatte umfassend das Papier nach Anspruch.

13. Verfahren zum Herstellen eines Papiers, umfassend:

Bilden einer Aufschlämmung von Polypyridobisimidazol-Fasern und wahlweise einem Bindermaterial; und
Entfernen von mindestens einem Teil des Wassers in einem oder mehreren Schritten, um ein Papier zu bilden;
wobei das Papier (i) eine Dichte von 0,08 bis 1,5 Gramm pro Kubikzentimeter und (ii) ein Basisgewicht von 10 bis 150 Gramm pro Quadratmeter aufweist, und das Papier, wenn es mit mindestens 15 Gew.-% Phenolharz imprägniert wird, eine spezifische Zugsteifigkeit von mindestens 100 (N/cm)/(g/$m^2$) aufweist, wobei das Gewichtsprozent auf dem Gesamtgewicht des Papiers und des Harzes basiert.

14. Verfahren nach Anspruch 13, ferner umfassend das Kalandrieren des gebildeten Papiers bei Zimmertemperatur oder erhöhter Temperatur.

15. Verfahren nach Anspruch 13, wobei die Polypyridobisimidazol-Faser PIPD ist.

**Revendications**

1. Papier utile en tant qu'élément structural, comprenant de 20 à 100 pour cent en poids de fibre de polypyridobisimidazole et optionnellement un matériau de liant, le papier ayant (i) une densité de 0,08 à 1,5 gramme par centimètre carré et (ii) un poids de base de 10 à 150 grammes par mètre carré, et le papier, lorsqu'il est imprégné avec au moins 15 % en poids de résine phénolique, a une rigidité de traction spécifique d'au moins 100 (N/cm)/(g/$cm^2$), le pourcentage en poids étant basé sur le poids total du papier et de la résine.

2. Papier selon la revendication 1, dans lequel le matériau de liant est choisi dans le groupe constitué de résines thermodures et thermoplastiques sous forme de solutions, émulsions, suspensions, poudres, flocons et fibres; fibrides; et pulpes de polymères autres que le polypyridobisimidazole.

3. Papier selon la revendication 1, dans lequel la fibre de polypyridbisimidazole est le PIPD.

4. Papier selon la revendication 1, ayant une rigidité de traction spécifique après imprégnation avec de la résine phénolique de 110-150 (N/cm)/(g/$m^2$).

5. Papier selon la revendication 1, ayant une porosité de Gurley-Hill de 1 à 20 secondes, préférablement de 5 à 12 secondes.

6. Papier selon la revendication 3, ayant de 70 à 90 % en poids de fibres de PIPD.

7. Papier selon la revendication 1, ayant une densité de 0,6 à 1,2 grammes par centimètre carré.

8. Papier selon la revendication 1, comprenant en outre au moins un des éléments suivants: des charges conductrices, des antioxydants, des pigments, et des catalyseurs.

9. Papier selon la revendication 1, dans lequel la fibre de PIPD est introduite dans le papier sous forme de floc.

10. Papier selon la revendication 1, dans lequel la fibre de PIPD est introduite dans le papier sous forme de pulpe.

11. Papier selon la revendication 1, dans lequel la fibre de PIPD est introduite dans le papier en tant que mélange de floc de PIPD et de pulpe de PIPD.

12. Noyau structurel, noyau alvéolaire, noyau de papier plié, circuit imprimé d'affichage ou panneau sandwich comprenant le papier selon la revendication 1.

13. Procédé pour la fabrication d'un papier, comprenant:

la formation d'une suspension de fibres de polypyridobisimidazole et optionnellement d'un liant ; et
l'élimination d'au moins une partie de l'eau en une ou plusieurs étapes pour former un papier ;
le papier ayant (i) une densité de 0,08 à 1,5 gramme par centimètre cube et (ii) un poids de base de 10 à 150 grammes par mètre carré et le papier, lorsqu'il est imprégné avec au moins 15% en poids de résine phénolique,

a une rigidité de traction spécifique d'au moins 100 (N/cm)/(g/$m^2$), le pourcentage en poids étant basé sur le poids total du papier et de la résine.

**14.** Procédé selon la revendication 13, comprenant en outre le calandrage du papier formé à température ambiante ou accrue.

**15.** Procédé selon la revendication 13, dans lequel la fibre de polypyridobisimidazole est le PIPD.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2999788 A
- US 3756908 A
- US 4472241 A
- US 4698267 A
- US 4729921 A
- US 5223094 A
- US 5314742 A
- US 5137768 A
- US 6544622 B
- US 3018091 A
- US 5674969 A, Sikkema
- US 5171402 A
- US 5084136 A, Haines


### Non-patent literature cited in the description


- **Brew et al.** *Composites Science and Technology,* 1999, vol. 59, 1109
- **Van der Jagt ; Beukers.** *Polymer,* 1999, vol. 40, 1035
- **Sikkema.** *Polymer,* 1998, vol. 39, 5981
- **Klop ; Lammers.** *Polymer,* 1998, vol. 39, 5987
- **Hageman et al.** *Polymer,* 1999, vol. 40, 1313
- **Smook, Gary A. ; Kocurek, M.J.** Handbook for Pulp & Paper Technologists. Technical Association of the Pulp and Paper Industry